**Europäisches Patentamt**

**European Patent Office**

**Office européen des brevets**

(19)

(11) Publication number : **0 436 907 B1**

## (12) EUROPEAN PATENT SPECIFICATION

(45) Date of publication of patent specification :
**12.07.95 Bulletin 95/28**

(51) Int. Cl.[6] : **H01L 23/31, H01L 25/16**

(21) Application number : **90125080.3**

(22) Date of filing : **21.12.90**

(54) **Resin mold packaged electronic parts.**

(30) Priority : **06.01.90 JP 801/90**

(43) Date of publication of application :
**17.07.91 Bulletin 91/29**

(45) Publication of the grant of the patent :
**12.07.95 Bulletin 95/28**

(84) Designated Contracting States :
**DE FR GB**

(56) References cited :
**EP-A- 0 217 678**
**US-A- 4 797 726**
**PATENT ABSTRACTS OF JAPAN vol. 10, no. 158 (E-409)(2214) 06 June 1986 & JP-A-61 014731**
**PATENT ABSTRACTS OF JAPAN vol. 10, no. 309 (E-447)(2365) 21 October 1986 & JP-A-61 123162**
**PATENT ABSTRACTS OF JAPAN vol. 6, no. 136 (E-120)(1014) 23 July 1982 & JP-A-57 060860**
**PATENT ABSTRACTS OF JAPAN vol. 10, no. 175 (E-413)(2231) 20 June 1986 & JP-A-61 024253**
**PATENT ABSTRACTS OF JAPAN vol. 9, no. 263 (E-351)(1986) 19 October 1985 & JP-A-60 109256**
**PATENT ABSTRACTS OF JAPAN vol. 12, no. 54 (E-583)(2901) 18 February 1988 & JP-A-62 200751**

(73) Proprietor : **FUJITSU LIMITED**
**1015, Kamikodanaka**
**Nakahara-ku**
**Kawasaki-shi Kanagawa 211 (JP)**

(72) Inventor : **Matsuzaki, Toshio, c/o Fujitsu Limited**
**Patent Department,**
**1015 Kamikodanaka,**
**Nakahara-ku**
**Kawasaki-shi, Kanagawa 211 (JP)**
Inventor : **Toshima, Hiroaki, c/o Fujitsu Limited**
**Patent Department,**
**1015 Kamikodanaka,**
**Nakahara-ku**
**Kawasaki-shi, Kanagawa 211 (JP)**
Inventor : **Hirasawa, Nobuo, c/o Fujitsu Limited**
**Patent Department,**
**1015 Kamikodanaka,**
**Nakahara-ku**
**Kawasaki-shi, Kanagawa 211 (JP)**

(74) Representative : **Sunderland, James Harry et al**
**HASELTINE LAKE & CO**
**Hazlitt House**
**28 Southampton Buildings**
**Chancery Lane**
**London WC2A 1AT (GB)**

EP 0 436 907 B1

## Description

The present invention relates to resin mold packaged electronic parts and, more particularly but not exclusively, to a structure of a circuit substrate used for forming a hybrid integrated circuit with a lead frame supporting the circuit substrate, wherein the circuit substrate has a comparatively large size and comprises a substrate and a plurality of active and passive elements disposed thereon, and the circuit substrate and a part of the lead frame are finally resin molded forming a package.

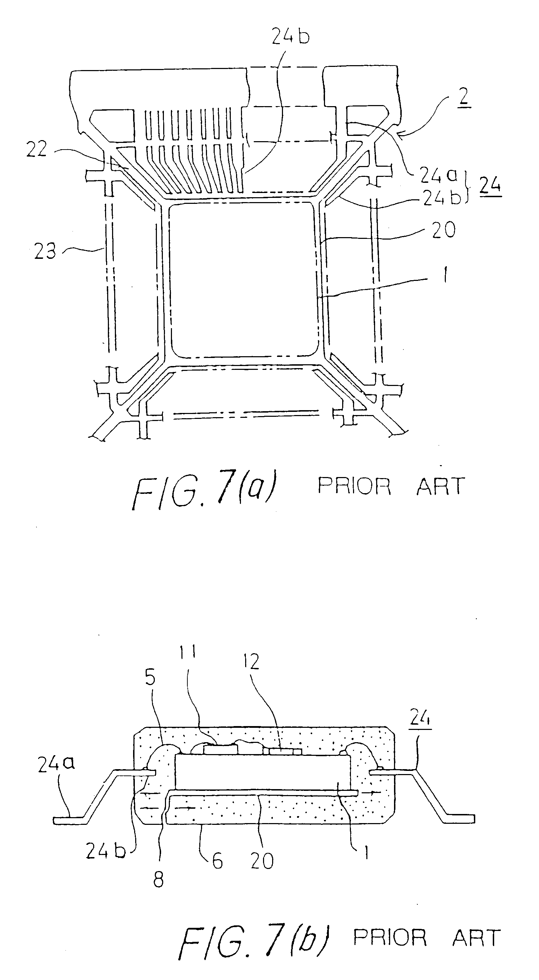

In recent years, resin molds are popularly used for packaging semiconductor integrated circuits or hybrid integrated circuits. In a mold package, a semiconductor integrated circuit chip or a substrate of ceramic having active and passive elements thereon is insert-molded with a lead frame. In case of hybrid integrated circuits, with the trend towards higher degrees of integration, dimensions of the circuit substrates and, accordingly, the mold packages are becoming larger. This trend has made manifest a cracking problem relating to the mold packages, which arises during storage and operation of packaged circuits due to differences in expansion coefficients and adhesion characteristics between molding resin, lead frame, ceramic substrate, etc. The problem will be briefly explained with reference to Figures 7(a) and 7(b).

Figures 7(a) and 7(b) show the structure of a hybrid integrated circuit of the prior art, wherein Figure 7(a) is a top view in which a mold package is absent, and Figure 7(b) is a cross-sectional view thereof.

A lead frame 2 comprises outer leads 24a, inner leads 24b, tie-bars 23, support-bars 22, and a support plate 20. The support plate 20 has a square or rectangular shape and is supported by four support-bars 22, one at each corner of the assumed square/rectangular shape. A ceramic substrate 1 is supported on the support plate 20 of the lead frame 2. As shown in Figure 7(b), a semiconductor integrated circuit chip 11, a capacitor 12, and a resistor (not shown) are disposed or formed on the substrate 1. These active and passive elements are connected mutually or connected to bonding pads by bonding wires or to a conductive wiring pattern formed on the substrate 1. The bonding wires and wiring pattern are not shown in Figure 7(a). The bonding pads are further connected to the terminals of the inner leads 24b by bonding wires 5 as shown in Figure 7(b). Thereafter the assembly is subjected to a transfer-mold process, forming a mold package 6 shown in Figure 7 (b), and finally the outer leads 24a are shaped, unnecessary portions of the lead frame 2 are cut off, and thus the hybrid integrated circuit is completed.

When the hybrid integrated circuit disclosed above is subjected to a number of heat cycles during operation, a crack 8 such as shown in Figure 7(b) which originates at the corner of the substrate 1 or the support plate 20 often arises in the mold package. Various proposals for package structures have been made with a view to solving this cracking problem. However, most of these proposals concern package structures for semiconductor integrated circuit chips, which have comparatively small sizes as compared with substrates for hybrid integrated circuits and are directly disposed on support plates of lead frames. These proposals concern methods in which holes or notched portions are formed in a peripheral zone of a support plate or a hole is formed in a central zone thereof.

According to the present invention there is provided a packaged electronic part, comprising a substrate, and a lead frame having a plurality of leads and a support plate, each lead having an inner lead part and an outer lead part, and a resin mold package packaging the substrate, support plate and inner lead parts, the support plate supporting the substrate from below and having an opening therein leaving the greater part of the bottom surface of the substrate (1) exposed to the material of the resin mold package, characterised in that the substrate comprises a plurality of devoid portions whereby the overall edge length of an outline of the substrate is increased, and the material of the resin mold package fills the devoid portions, whereby adhesion between the substrate and the resin mold package is improved.

An embodiment of the present invention can provide a mold packaged hybrid integrated circuit which is more resistant to adverse effects of heat cycles during operation of the circuit.

An embodiment of the present invention can provide a mold packaged hybrid integrated circuit in which adhesion between resin mold and a ceramic substrate of the circuit is stronger than in prior art structures.

An embodiment of the present invention can provide a mold packaged hybrid integrated circuit which offers higher reliability over repeated heat cycles during operation of the circuit.

An embodiment of the present invention can provide a mold packaged hybrid integrated circuit which is more resistant to the effects of gas released from the moisture absorbing mold during storage.

In an embodiment of the present invention a hybrid integrated circuit comprises a substrate, at least one active element and passive element being disposed thereon, a lead frame having a plurality of leads and a support plate, each lead having an inner lead and an outer lead, and a mold for packaging said substrate, support plate and inner leads; wherein an opening is formed in the support plate for exposing the bottom surface of the substrate to the mold, and wherein a plurality of devoid portions are formed in the substrate, whereby an overall fringe or edge length defining an outline of the substrate is prolonged or extended and adhesion between the substrate and the mold is improved.

The above devoid portions may be of any notch-like shape formed on the periphery of the substrate or may be through-holes formed in an inner surface of the substrate, or a combination of the above two types of portion. With these devoid portions, adhesion of the substrate to the mold package of epoxy resin is made stronger and probability of crack or peeling off failures in the mold package is reduced remarkably.

Embodiments of the present invention can provide resin mold packaged electronic parts other that hybrid integrated circuits. For example, an embodiment of the present invention can provide a resin mold packaged large scale integrated circuit.

Reference is made, by way of example, to the accompanying drawings, in which:-

Figures 1(a) and 1(b) are, respectively, a plan view and a schematic cross-sectional view of a hybrid integrated circuit, a mold package being removed in Figure 1(a), of a type in which in place of a support plate four stages are used for supporting a substrate, whereby the most part of the bottom surface of a substrate is exposed to the mold,

Figure 2(a) illustrates failure patterns of a mold package in accordance with 1(a) and 1(b) as tested by an ultrasonic reflectscope, in which broken line curves show peeling-off portions of the mold package which originate in the stage at the corners,

Figures 2(b) and 2(c) are schematic cross-sections of a failed device, in which Figure 2(b) corresponds to the failure state shown in Figure 2(a) and Figure 2(c) corresponds to the failed device when the failure state of Figure 2(a) has developed into a crack,

Figure 3(a) is a plan view of a hybrid integrated circuit in accordance with an embodiment of the present invention, with a mold package absent, with a lead frame having four stages and connecting-bars therebetween, and a substrate having a plurality of devoid portions of a semicircular shape formed on the periphery of the substrate, and a plurality of through-holes being devoid portions formed on lines spaced apart from each side of the square substrate,

Figure 3(b) is a schematic cross-sectional view of the device shown in Figure 3(a) after mold packaging,

Figure 4 is a top view of a substrate used for another embodiment of the present invention, in which a plurality of devoid portions are formed on the periphery of the substrate only,

Figure 5 is a top view of a substrate used for still another embodiment of the present invention, in which a plurality of devoid portions of the through-hole type are formed on lines near the periphery of the substrate only,

Figure 6 is a top view of a substrate used for still another embodiment of the present invention, in which a plurality of devoid portions of through-hole type are formed distributed over the entire surface of the substrate, and

Figures 7(a) and 7(b) are a plan view and a schematic cross-sectional view of a hybrid integrated circuit of the prior art, in which a square support plate is used for supporting a substrate, a mold package being absent in Figure 7(a), and a crack failure being shown in Figure 7(b).

In order to solve problems which are experienced in the package structures of hybrid integrated circuits, it has been proposed (in U.S. Patent Application Serial No. 375,708 filed July 5, 1989) by Toshio MATSUZAKI and Hiroaki TOSHIMA to provide a lead frame having a large opening in a support plate thereof. T. Matsuzaki is one of the inventors of the invention the subject of the present application. In a hybrid integrated circuit package according to the above proposal, a circuit substrate is supported on the remaining small area of the support plate and a large portion of the bottom surface of the circuit substrate is exposed to the mold package resin and fixed therewith. A hybrid integrated circuit package according to this proposal is characterised in that the surface area of the circuit substrate is greater than 60% of a principal surface area of the mold package and that the bottom surface exposed to the mold package is greater than 50%, preferably 90%, of the entire bottom surface of the circuit substrate. A number of different support plate shapes are proposed. Shapes such as a square outline having a square opening therein, four square stages formed at each corner of an assumed square shape, four square stages having connecting bars between adjacent stages, etc. are proposed.

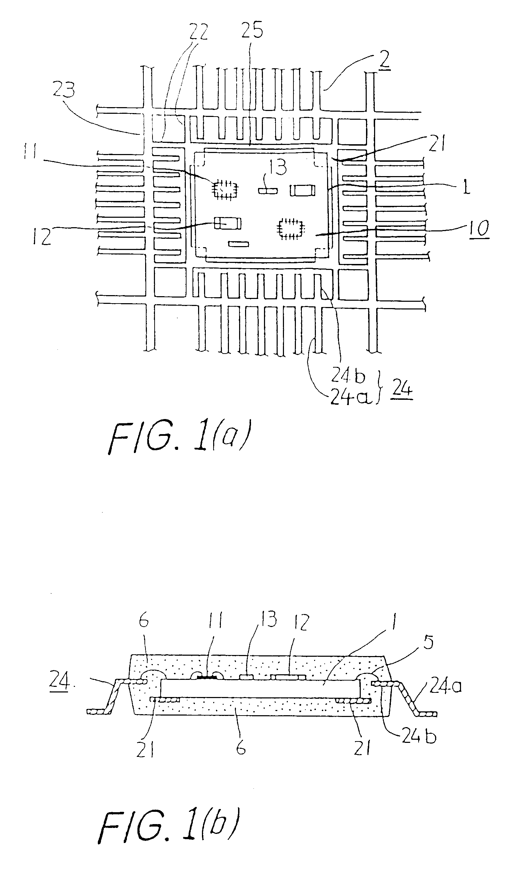

Figures 1(a) and 1(b) show a structure of a hybrid integrated circuit in accordance with the above proposal, wherein Figure 1(a) is a top view in which a mold package is absent, and Figure 1(b) is a cross-sectional view thereof. A lead frame 2 comprises outer leads 24a, inner leads 24b, tie-bars 23, support-bars 22, stages 21 and connecting-bars 25. Four stages 21 are formed at respective corners of an assumed square shape, connected by connecting-bars 25 and supported by two support-bars 22 at each corner of the assumed square shape. A square-shape ceramic substrate 1 is supported on the four stages 21 of the lead frame 2, replacing the square support plate of the prior art. The greater part of the bottom surface of the ceramic substrate 1 is exposed to the mold package.

On the ceramic substrate 1, a semiconductor integrated circuit chip 11, a capacitor 12, and a resistor 13 are disposed and fixed, forming a circuit substrate 10. These active and passive elements are connected mutually or connected to bonding pads by bonding wire or to a conductive wiring pattern formed on the substrate 1. The bonding wires and wiring patterns are not shown in the Figure 1(a). The bonding pads are further connected to the terminals of the inner leads 24b by bonding wires 5 as shown in Figure 1(b). Thereafter the assembly is subjected to a transfer-mold process, forming a mold package 6 shown in Figure 1(b), and finally the outer leads 24a are shaped, unnecessary portions of the lead frame 2 are cut off, and thus the hybrid integrated circuit is completed.

The mold package as disclosed in Figures 1(a) and 1(b) has shown a remarkable improvement over other prior art structures. However, the package structure as described above absorbs moisture within the resin mold during a storage period after fabrication. When it is installed on a printed circuit board and subjected to a soldering process and thereafter put into operation including repeated heat cycles, the mold material releases a gas of the absorbed moisture, and the gas expands causing several kinds of defects.

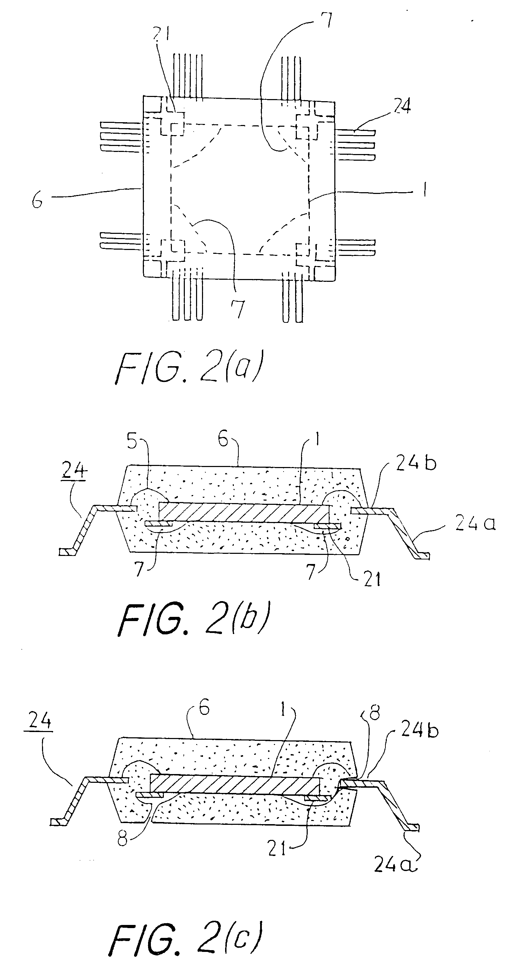

Figures 2(a), 2(b) and 2(c) illustrate examples of failure states of the mold package of Figure 1. Figure 2(a) gives a schematic top view of failure patterns, in which the package uses a lead frame 2 having four stages 21 and connecting-bars between stages are not used. A ceramic substrate 1 having a square shape (an outline thereof is shown by broken lines and active and passive elements thereon are omitted) is supported on the four stages 21. Figure 2(b) is a schematic cross-sectional view of the failed package structure of Figure 2(a). Figures 2(a) and 2(b) show failure patterns at an early stage.

Tests for detecting the failure patterns are performed utilizing an ultrasonic reflectscope, the mold package to be tested being immersed in water and subjected to ultrasonic irradiation, and reflected ultrasonic waves being received by a sensor. Detecting positions are established every 50 microns, scanning the entire surface of the mold package. This is a non-destructive test method and is widely used. It takes about 5 minutes for scanning the entire surface of the mold package, and the detected data is image-processed and displayed on a screen.

Dashed curves in Figure 2(a) show portions 7 at which peeling off is detected, in which the mold 6 is slightly separated from the stages 21. When they progress, such peeling off failures develop into crack failures 8, which are shown in Figure 2(c). In Figure 2(c), one crack appears on the bottom surface of the mold 6 and the other appears between the inner lead 24b and the mold. Such peeling off defects cannot be detected by visual inspection at an early stage of failure, which originate from the four stages 21 supporting the substrate 1.

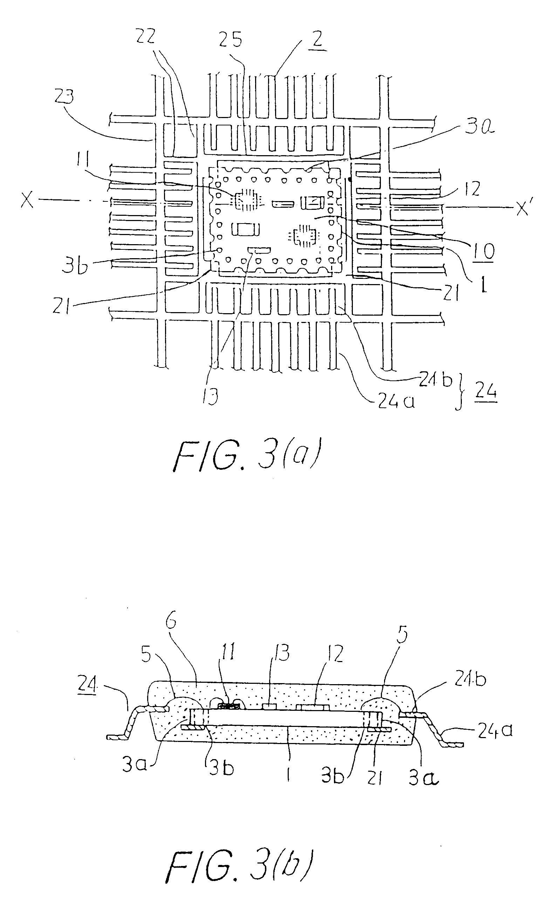

Figure 3(a) is a plan view of a hybrid integrated circuit in accordance with an embodiment of the present invention, with a mold package absent. Figure 3(b) is a schematic cross-sectional view of the device shown in Figure 3(a) after mold packaging.

A lead frame 2 has a similar structure to that explained with reference to Figure 1(a), wherein four stages 21 are formed at respective corners of an assumed square and connected by four connecting-bars 25, and each stage is supported by two support-bars 22 which are connected to adjacently arranged tie-bars 23. In this type of the lead frame 2, a support plate for supporting a substrate 1 consists of four stages 21, each having a small area and therefore most of the bottom surface of the substrate 1 is exposed (not covered by the support plate) and contacts with a mold. A plurality of leads 24 are provided in the lead frame 2, each lead having an outer lead 24a and an inner lead 24b.

A circuit substrate 10 comprises the substrate 1, a semiconductor integrated circuit chip 11 as an active element, and a capacitor 12 and a resistor 13 as a passive element. These active and passive elements are disposed and fixed on the substrate 1, and electrical connections between terminals of these elements and a printed circuit pattern (not shown) on the substrate 1 are made by a bonding wire 5 or a direct soldering.

The circuit substrate 10 is disposed on four stages 21 of the lead frame 2, and each inner lead 24b terminal is connected to a bonding pad (not shown) on the substrate 1 by a bonding wire 5.

In the illustrated embodiment, the substrate 1 is made of ceramic and has a thickness of 0.6 mm and a surface area of 23 x 23 mm. On each side of the square, a plurality of devoid or cut-out portions 3a are formed at regular intervals of 1.6 mm between adjacent devoid or cut-out portions, each portion having the shape of a semicircle 0.4 mm in diameter. The shape of the devoid or cut-out portions and the intervals therebetween are not restricted to those described. The shape may be elliptical, V-shaped, etc. It is necessary that the notch-like devoid or cut-out portions 3a are formed on the periphery of the ceramic substrate 1 and result in an elongation of the actual length of the periphery of the substrate contacting with a mold, which increases the strength of the adhesion force between the substrate 1 and the mold 6 after packaging.

As shown in Figure 3(a), the substrate 1 of the illustrated embodiment further includes a plurality of devoid or aperture portions 3b of a through-hole type, having a diameter of 0.2 mm, and having a regular interval of 1.6 mm arranged on lines spaced 2 mm apart from respective sides of the square.

Using the above circuit substrate 10 with active and passive elements thereon, the lead frame 2 and the circuit substrate 10 are subjected to a transfer-mold process using a thermosetting resin such as epoxy resin.

After molding, the outer leads 24a are shaped and unnecessary portions are cut off, to complete fabrication of a hybrid integrated circuit of a PQFP (Plastic Quad-Flat Package) type having outline dimensions of 28 x 28 x 4 mm.

Figure 3(b) is a schematic cross-sectional view of the completed hybrid integrated circuit, taken along a line X-X' in Figure 3(a). Though the stages 21 are not positioned on the line X-X', stages 21 are illustrated in Figure 3(b) for easy understanding, and it is clear that the stages 21 are below the level of the inner leads 24b.

Hybrid integrated circuits embodying the present invention formed using substrates of the above type are hereinafter conveniently called test piece group 1, in which devoid portions are formed along the periphery of the substrates and on lines inwardly spaced apart from each side of the square substrate, and four stages are utilized as a support.

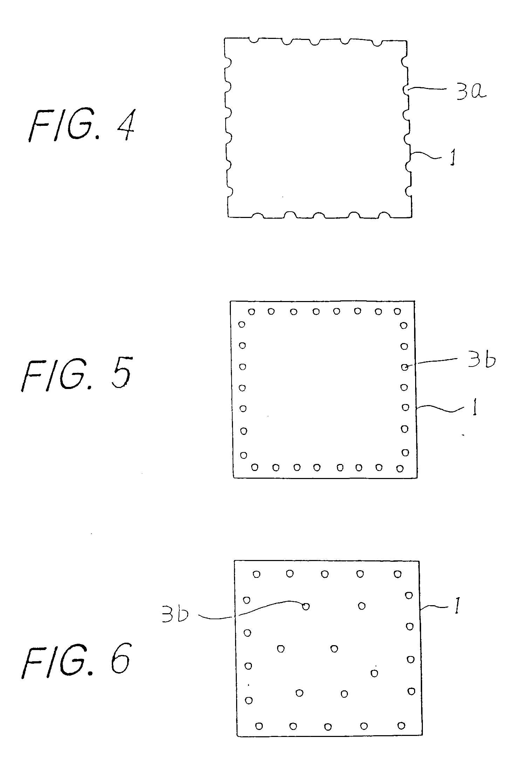

Another embodiment of the present invention utilizes a substrate shown in Figure 4, other structures of the embodiment being the same as those shown in Figures 3(a) and 3(b). The substrate of the type shown in Figure 4 has a plurality of devoid portions 3a only on the periphery of the square substrate, and has no through-holes as shown in Figure 3(a). The number of the devoid portions 3a, their size and their arrangement are the same as those of Figure 3(a), each having the shape of a semicircle with a diameter of 0.4 mm and being arranged at regular intervals of 1.6 mm. Hybrid integrated circuits embodying the present invention formed using substrates as shown in Figure 4 are called test piece group 2.

Still another embodiment of the present invention utilizes a substrate type as shown in Figure 5. The substrate 1 of this type has a plurality of devoid or aperture portions 3b of a through-hole type and has no devoid or cut-out portion along the periphery of the substrate 1. The number of through-holes 3b, their size and their arrangement are the same as those of Figure 3(a), each through-hole having a diameter of 0.2 mm and being arranged on lines spaced 2 mm inwardly from each side of the square substrate and at regular intervals of 1.6 mm. Hybrid integrated circuits embodying the present invention formed using substrates as shown in Fig. 5 are called test piece group 3.

Still a further embodiment of the present invention utilizes a substrate type as shown in Figure 6. The substrate 1 of this type has a plurality of devoid or aperture portions 3b of a through-hole type and has no devoid or cut-out portions along the periphery of the substrate 1. The disposition of the through-holes 3b on the substrate 1 is determined such that the through-holes do not obstruct the mounting of active or passive elements and are not disposed on a printed pattern on the substrate 1. In this embodiment, each through-hole 3b has a diameter of 0.2 mm and a total of 150 through-holes 3b are formed with appropriate intervals therebetween. Hybrid integrated circuits embodying the present invention formed using substrates as shown in Fig. 6 are called test piece group 4.

Besides the above four test piece groups, an additional group of test pieces was provided for comparison purposes (called the comparison group), in which the substrate has no devoid portions on the periphery or on the inner surface of the substrate 1.

Each group of test pieces was subjected to the conditions of an ambient temperature of 85°C and a humidity of 85%, and stored separated into sub-groups, for 24, 48, 96 and 192 hours respectively. Thereafter, the test pieces were subjected to heat shock tests under two different conditions. One involves a reflow soldering method in which test pieces are irradiated by infrared rays, and the other involves a dip soldering method in which test pieces are dipped in spouting hot solder. The maximum soldering temperature was set at 260°C for both methods. Therefore, for each of the test piece groups 1 to 4 and the comparison group without devoid portions, eight sub-groups of test pieces were prepared and subjected to eight different test conditions.

Thereafter, all test pieces were inspected by ultrasonic reflectscope. The test results are shown in Table 1.

As expected, it turns out that the dip soldering method is generally more severe than the reflow soldering method. For the comparison group, using substrates without devoid portions, the test results show a high percentage of package failure except only that the test pieces stored for 24 hours are safe for both soldering methods.

On the other hand, groups 1 and 4, of test pieces in accordance with the present invention proved to be completely safe for both soldering tests and under any of the storage conditions without failures. Further, groups 2 and 3 also showed a remarkable improvement in the package strength compared with the structure without the devoid portions.

| Soldering Method | Storage Condition | Test Piece Group Number | | | | Comp. Group |
|---|---|---|---|---|---|---|
| | | 1 | 2 | 3 | 4 | |
| Reflow Soldering by Infra-red Rays | 85°C-85%-24H | ○ | ○ | ○ | ○ | ○ |
| | 85°C-85%-48H | ○ | ○ | ○ | ○ | ○ |
| | 85°C-85%-96H | ○ | ○ | ○ | ○ | ▲ |
| | 85°C-85%-192H | ○ | ▲ | ○ | ○ | ▲ |
| Dip-Soldering | 85°C-85%-24H | ○ | ○ | ○ | ○ | ○ |
| | 85°C-85%-48H | ○ | ○ | ○ | ○ | ▲ |
| | 85°C-85%-96H | ○ | ▲ | ○ | ○ | ● |
| | 85°C-85%-192H | ○ | ● | ▲ | ○ | ● |

○ : No defect.
▲ : Some of test pieces in the sub-group show peeling-off defect.
● : All test pieces show peeling-off defect or crack defect.

Table 1

In the above description of the embodiments of the present invention, all active and passive elements are indicated to be disposed on the front surface of the substrate 1. However, elements may be disposed on the bottom surface of the substrate 1. In this case, a through-hole for connecting two points positioned respectively on the front and bottom surfaces of the substrate is necessary. The devoid portions 3a or 3b of the present invention can be utilised for this purpose.

In the illustrated embodiments, devoid portions have a semicircular shape on the periphery of the substrate 1 and a circular shape on the inner surface thereof. However, any shape can be used for the devoid portions in embodiments of the present invention. The arrangements of these devoid portions on the surface and the intervals between adjacent two devoid portions are not restricted; they need not be uniform, but may be arbitrary.

Embodiments of the present invention may also be applied to large scale semiconductor integrated circuits, in which a ceramic substrate is not used but a semiconductor substrate of a large size is directly disposed on the stages of a lead frame, a plurality of devoid portions being formed in the semiconductor substrate.

An embodiment of the present invention provides a hybrid integrated circuit, comprising a substrate, at least one active element and one passive element being disposed thereon, a lead frame having a plurality of leads and a support plate, each lead having an inner lead and an outer lead, and a resin mold for packaging said substrate, support plate and inner leads; wherein an opening is formed in the support plate for exposing the bottom surface of the substrate to the mold, and wherein a plurality of devoid portions are formed in the substrate, thereby overall fringe defining an outline of the substrate being prolonged and adhesion between the substrate and the mold being improved.

## Claims

1. A packaged electronic part, comprising a substrate (1), and a lead frame (2) having a plurality of leads (24) and a support plate (21), each lead (24) having an inner lead part (24b) and an outer lead part (24a), and a resin mold package (6) packaging the substrate (1), support plate (21) and inner lead parts (24b), the support plate (21) supporting the substrate (1) from below and having an opening therein leaving the greater part of the bottom surface of the substrate (1) exposed to the material of the resin mold package, characterised in that
the substrate (1) comprises a plurality of devoid portions (3a, 3b) whereby the overall edge length of an outline of the substrate (1) is increased, and the material of the resin mold package (6) fills the devoid portions (3a, 3b), whereby adhesion between the substrate (1) and the resin mold package (6) is improved.

2. A packaged electronic part as claimed in claim 1, being a packaged large scale semiconductor integrated circuit, the substrate being a semiconductor substrate.

3. A packaged electronic part as claimed in claim 1, being a packaged hybrid integrated circuit, the substrate (1) having at least one active element (11) and one passive element (12, 13) disposed thereon.

4. A packaged electronic part as claimed in any preceding claim, wherein the plurality of devoid portions in the substrate (1) comprises or consists of portions (3a) formed along a periphery of the substrate, each such portion (3a) having a notch-like structure having, for example, the shape of a semicircle, or a V-shape, or a U-shape or a combination thereof.

5. A packaged electronic part as claimed in claim 4, wherein the portions (3a) formed along a periphery of the substrate (1) are formed at regular intervals along the periphery.

6. A packaged electronic part as claimed in any preceding claim, wherein the plurality of devoid portions in the substrate (1) comprises or consists of through-holes (3b) penetrating through the substrate (1) formed within the inner surface thereof.

7. A packaged electronic part as claimed in claim 6, wherein the through-holes (3b) are formed on one or more lines spaced apart from and adjacent to each side of a square-shaped or rectangular-shaped substrate.

8. A packaged electronic part as claimed in claim 6 or claim 7, wherein through-holes (3b) are formed in the substrate avoiding the positions on which active and/or passive elements and/or related connection means are arranged.

9. A packaged electronic part as claimed in any preceding claim, wherein the support plate (21) comprises four stages arranged one at each corner of an assumed square or rectangular shape, the four stages supporting the substrate (1).


**Patentansprüche**

1. Ein verpacktes elektronisches Teil, das ein Substrat (1) umfaßt, und einen Leitungsrahmen (2), der eine Mehrzahl von Leitungen (24) und eine Stützplatte (21) aufweist, wobei jede Leitung (24) einen inneren Leitungsteil (24b) und einen äußeren Leitungsteil (24a) aufweist, und eine Harzformverpackung (6), in der das Substrat (1), die Stützplatte (21) und die inneren Leitungsteile (24b) verpackt sind, wobei die Stützplatte (21) das Substrat (1) von unten stützt und in sich eine Öffnung aufweist, die den größeren Teil der unteren Oberfläche des Substrates (1) dem Material der Harzformverpackung ausgesetzt läßt, dadurch gekennzeichnet, daß
das Substrat (1) eine Mehrzahl von freien Teilen (3a, 3b) umfaßt, wodurch die Gesamtkantenlänge eines Umrisses des Substrates (1) erhöht wird, und das Material der Harzformverpackung (6) die freien Teile (3a, 3b) auffüllt, wodurch die Adhäsion zwischen dem Substrat (1) und der Harzformverpackung (6) verbessert wird.

2. Ein verpacktes elektronisches Teil nach Anspruch 1, das ein verpackter größtintegrierter Halbleiterschaltkreis ist, wobei das Substrat ein Halbleitersubstrat ist.

3. Ein verpacktes elektronisches Teil nach Anspruch 1, das ein verpackter integrierter Hybridschaltkreis ist, wobei das Substrat (1) wenigstens ein aktives Element (11) aufweist, sowie ein passives Element (12, 13), die darauf angeordnet sind.

4. Ein verpacktes elektronisches Teil nach einem der vorigen Ansprüche, worin die Mehrzahl von freien Teilen in dem Substrat (1) aus Teilen (3a) besteht oder solche. umfaßt, die entlang einer Peripherie des Substrates ausgebildet sind, wobei ein jeder dieser Teile (3a) eine kerbähnliche Struktur aufweist, die beispielsweise die Form eines Halbkreises, eine V-Form, oder eine U-Form, oder eine Kombination daraus aufweist.

5. Ein verpacktes elektronisches Teil nach Anspruch 4, worin die Teile (3a), die entlang einer Peripherie des Substrates (1) gebildet sind, in gleichmäßigen Abständen entlang der Peripherie ausgebildet sind.

**6.** Ein verpacktes elektronisches Teil nach einem der vorigen Ansprüche, worin die Mehrzahl der freien Teile in dem Substrat aus Durchgangsöffnungen (3b) besteht oder diese umfaßt, die das Substrat (1) durchdringen und innerhalb seiner inneren Oberfläche ausgebildet sind.

**7.** Ein verpacktes elektronisches Teil nach Anspruch 6, worin die Durchgangsöffnungen (3b) auf einer oder auf mehreren Linien ausgebildet sind, die von jeder Seite eines quadratisch geformten oder eines rechteckig geformten Substrates beabstandet sind und benachbart verlaufen.

**8.** Ein verpacktes elektronisches Teil nach Anspruch 6 oder 7, worin die Durchgangsöffnungen (3b) in dem Substrat ausgebildet sind und die Positionen auslassen, auf denen aktive und/oder passive Elemente und/oder zugehörige Verbindungsmittel angeordnet sind.

**9.** Ein verpacktes elektronisches Teil nach einem der vorigen Ansprüche, worin die Stützplatte (21) vier Abschnitte umfaßt, die jeweils auf einer jeden Ecke einer angenommenen quadratischen oder rechteckigen Form angeordnet sind, wobei die vier Abschnitte das Substrat (1) stützen.


**Revendications**

**1.** Composant électronique encapsulé, comprenant un substrat (1) et une grille de connexion (2) ayant une pluralité de conducteurs (24) et une plaque formant support (21), chaque conducteur (24) ayant une partie intérieure de conducteur (24b) et une partie extérieure de conducteur (24a), et un boîtier moulé en résine (6) encapsulant le substrat (1), la plaque formant support (21) et les parties intérieures de conducteur (24b), la plaque formant support (21) supportant le substrat de par-dessous et ayant une ouverture dans celle-ci laissant la plus grande partie de la surface inférieure du substrat (1) exposée à la matière du boîtier moulé en résine,
caractérisé en ce que:
    - le substrat (1) comprend une pluralité de parties vides (3a, 3b), ce par quoi la longueur totale du bord du contour du substrat (1) est augmentée et la matière du boîtier moulé en résine remplit les parties vides (3a, 3b), ce par quoi l'adhérence entre le substrat (1) et le boîtier moulé en résine (6) est améliorée.

**2.** Composant électronique encapsulé selon la revendication 1, le composant étant un circuit intégré à haute densité de composants (circuit LSI), le substrat étant un substrat de semiconducteur.

**3.** Composant électronique encapsulé selon la revendication 1, le composant étant un circuit intégré hybride encapsulé, le substrat (1) ayant au moins un élément actif (11) et un élément passif (12, 13) disposés sur celui-ci.

**4.** Composant électronique encapsulé selon l'une quelconque des revendications précédentes, dans lequel la pluralité de parties vides du substrat (1) comprend ou est composée de parties (3a) formées le long de la périphérie du substrat, chacune de ces parties (3a) ayant une structure comme une encoche ayant, par exemple, la forme d'un demi-cercle ou une forme en V, ou une forme en U, ou une combinaison de celles-ci.

**5.** Composant électronique encapsulé selon la revendication 4, dans lequel les parties (3a) formées le long de la périphérie du substrat (1) sont formées à des intervalles réguliers le long de la périphérie.

**6.** Composant électronique encapsulé selon l'une des revendications précédentes, dans lequel la pluralité de parties vides du substrat (1) comprend ou est composée de trous traversants (3b) pénétrant à travers le substrat (1) formés dans la surface intérieure de celui-ci.

**7.** Composant électronique encapsulé selon la revendication 6, dans lequel les trous traversants (3b) sont formés sur une ou plusieurs lignes espacées et voisines de chaque bord d'un substrat de forme carrée ou rectangulaire.

**8.** Composant électronique encapsulé selon la revendication 6 ou 7, dans lequel les trous traversants (3b) sont formés dans le substrat en évitant les positions auxquelles des éléments actifs et/ou passifs et/ou les moyens de connexion associés sont disposés.

9. Composant électronique encapsulé selon l'une quelconque des revendications précédentes, dans lequel la plaque formant support (21) comprend quatre avancées disposées une à chaque coin d'une ouverture de forme supposée carrée ou rectangulaire, les quatre avancées supportant le substrat (1).

FIG. 1(a)

FIG. 1(b)

FIG. 2(a)

FIG. 2(b)

FIG. 2(c)

FIG. 3(a)

FIG. 3(b)

FIG. 4

3a

1

FIG. 5

3b

1

FIG. 6

3b

1

FIG. 7(a)    PRIOR ART

FIG. 7(b)    PRIOR ART